# EUROPÄISCHE PATENTANMELDUNG

(11) **EP 4 807 968 A1**
(43) Veröffentlichungstag der Anmeldung: **16.09.2026**
(21) Anmeldenummer: 26164432.2
(22) Anmeldetag: 12.03.2026
(51) Int. Cl.: H02M 7/217, H02M 7/219, H03K 17/687

(54) **ANTRIEBSVORRICHTUNG FÜR EIN ÖFFNUNGSELEMENT EINES GEBÄUDES, SOWIE EINE GLEICHRICHTERSCHALTUNG ZUR VERSORGUNG EINES ELEKTRISCHEN ANTRIEBS**

(30) Priorität: 13.03.2025 DE 102025109684
(71) Anmelder: GEZE GmbH, 71229 Leonberg (DE)
(72) Erfinder: Banucu, Remus, 75328 Schömberg (DE); Egorenkov, Sergej, 70437 Stuttgart (DE)
(74) Vertreter: Witte, Weller & Partner Patentanwälte mbB

(57) **Zusammenfassung**

Die Erfindung betrifft eine Antriebsvorrichtung für ein Öffnungselement, bspw. eine Tür, ein Fenster oder dgl., eines Gebäudes, mit einem elektrischen Antrieb zum Öffnen und/oder Schließen des Öffnungselements, und einer Gleichrichterschaltung (10), die aufweist: einen ersten und einem zweiten Eingang (12.1, 12.2), an denen eine Eingangsspannung anlegbar ist; einem ersten und einem zweiten Ausgang (14.1, 14.2), die mit dem elektrischen Antrieb verbunden sind; vier über Steuereingänge steuerbare Schaltelemente (22, 24, 26, 28), wobei ein erstes und ein zweites Schaltelement (22, 24) in Reihe zwischen dem ersten Eingang und dem zweiten Eingang angeordnet sind und zwischen sich einen ersten Verbindungspunkt bilden, der mit dem ersten Ausgang verbunden ist, und wobei ein drittes und ein viertes Schaltelement (26, 28) in Reihe zwischen dem ersten Eingang und dem zweiten Eingang angeordnet sind und zwischen sich einen zweiten Verbindungspunkt bilden, der mit dem zweiten Ausgang verbunden ist; einer Steuerschaltung (30; 32, 34, 36, 38), die so konfiguriert ist, dass sie die Schaltelemente abhängig von der Polung der Eingangsspannung paarweise über die Steuereingänge ansteuert, wobei ein erstes Paar aus dem ersten Schaltelement (22) und dem vierten Schaltelement (28) gebildet ist, und ein zweites Paar aus dem zweiten Schaltelement (24) und dem dritten Schaltelement (26) gebildet ist, um den Stromfluss unabhängig von der Polung der Eingangsspannung durch die elektrische Last in einer Richtung zu ermöglichen. Die Antriebsvorrichtung ist gekennzeichnet durch vier richtungsabhängige Schaltungselemente (42, 44, 46, 48), wobei jedem Schaltelement jeweils ein richtungsabhängiges Schaltungselement zugeordnet ist, dergestalt, dass ein richtungsabhängiges Schaltungselement mit dem Steuereingang des zugeordneten Schaltelements und dem ersten oder dem zweiten Eingang verbunden ist.

## Beschreibung

Die vorliegende Erfindung betrifft eine Antriebsvorrichtung für ein Öffnungselement, bspw. eine Tür, ein Fenster oder dgl., eines Gebäudes, sowie eine Gleichrichterschaltung zur Versorgung eines elektrischen Antriebs für ein Öffnungselement eines Gebäudes mit einer Eingangsspannung.

Sehr häufig sind solche Antriebsvorrichtungen mit Gleichrichterschaltungen ausgerüstet, die einen Verpolungsschutz bereitstellen sollen. Ein solcher Verpolungsschutz kann dabei bspw. auf unterschiedliche Weisen umgesetzt werden.

Zum einen kommt eine elektronische Lösung zum Einsatz, bei der vier Dioden in einer Brückenschaltung angeordnet sind. Eine solche Brückenschaltung ist bspw. in DE10 2014 105 334 A1 gezeigt. Diese Schaltungsanordnung, die in Figur 4a gezeigt ist, gewährleistet, dass am Ausgang des Verpolungsschutzes stets eine Spannung mit einer definierten Polung zur Verfügung steht, unabhängig davon, wie die Spannungsquelle an die Eingänge der Schaltung angeschlossen wird. Auf diese Weise wird der Antrieb effektiv vor elektrischen Schäden geschützt und ein zuverlässiger Betrieb sichergestellt.

Zum anderen ist ein mechanischer Verpolungsschutz bekannt, der durch die Verwendung speziell gestalteter Steckverbinder realisiert wird, wie bspw. in DE19949453 A1 gezeigt. Diese Steckverbinder sind so ausgeführt, dass sie ausschließlich in einer korrekten Orientierung verbunden werden können, wodurch ein falscher elektrischer Anschluss bereits physisch verhindert wird. Durch die Kombination aus elektronischem und mechanischem Verpolungsschutz wird eine besonders hohe Betriebssicherheit des Antriebs gewährleistet, die sowohl die Elektronik als auch die Anwenderfreundlichkeit optimiert.

Aus dem Stand der Technik, DE 3133518 A1, ist zudem eine Gleichrichterschaltung bekannt, wie sie in Figur 4b gezeigt ist. Diese Schaltung nutzt Transistoren als wesentliche Bauelemente zur Gleichrichtung der Eingangsspannung.

Die Nachteile der aus DE 3133518 A1 bekannten Gleichrichterschaltung besteht darin, dass sogenannte Shoot-Through-Effekte, also Kurzschlüsse, entstehen können, wenn zwei Schaltelemente einer Reihenschaltung gleichzeitig leitend werden. Solche Kurzschlüsse führen zu hohen Verlustströmen und können die Schaltung dauerhaft beschädigen.

Die vorliegende Erfindung hat sich zum Ziel gesetzt, die beschriebenen Nachteile des Standes der Technik zu überwinden. Es soll eine Antriebsvorrichtung mit einer Gleichrichterschaltung entwickelt werden, die bei minimalem Spannungsabfall arbeitet, eine deutlich reduzierte Verlustleistung aufweist und sowohl die Anforderungen an die Kühlung als auch den Platzbedarf auf der Leiterplatte signifikant verringert.

Die der Erfindung zugrundeliegende Aufgabe wird durch eine Antriebsvorrichtung mit den Merkmalen des Anspruchs 1 gelöst. Insbesondere weist die Antriebsvorrichtung einen elektrischen Antrieb zum Öffnen und/oder Schließen des Öffnungselements, und eine Gleichrichterschaltung auf. Die Gleichrichterschaltung weist auf: einen ersten und einem zweiten Eingang, an denen eine Eingangsspannung anlegbar ist; einem ersten und einem zweiten Ausgang, die mit dem elektrischen Antrieb verbunden sind; vier über Steuereingänge steuerbare Schaltelemente, wobei ein erstes und ein zweites Schaltelement in Reihe zwischen dem ersten Eingang und dem zweiten Eingang angeordnet sind und zwischen sich einen ersten Verbindungspunkt bilden, der mit dem ersten Ausgang verbunden ist, und wobei ein drittes und ein viertes Schaltelement in Reihe zwischen dem ersten Eingang und dem zweiten Eingang angeordnet sind und zwischen sich einen zweiten Verbindungspunkt bilden, der mit dem zweiten Ausgang verbunden ist; einer Steuerschaltung, die so konfiguriert ist, dass sie die Schaltelemente abhängig von der Polung der Eingangsspannung paarweise über die Steuereingänge ansteuert, wobei ein erstes Paar aus dem ersten Schaltelement und dem vierten Schaltelement gebildet ist, und ein zweites Paar aus dem zweiten Schaltelement und dem dritten Schaltelement gebildet ist, um den Stromfluss unabhängig von der Polung der Eingangsspannung durch die elektrische Last in einer Richtung zu ermöglichen. Die erfindungsgemäße Gleichrichterschaltung umfass vier richtungsabhängige Schaltungselemente, wobei jedem Schaltelement jeweils ein richtungsabhängiges Schaltungselement zugeordnet ist, dergestalt, dass ein richtungsabhängiges Schaltungselement mit dem Steuereingang des zugeordneten Schaltelements und dem ersten oder dem zweiten Eingang verbunden ist.

Die vorliegende Gleichrichterschaltung bietet eine Reihe von entscheidenden Vorteilen, die sie besonders effizient, sicher und zuverlässig machen. Ein Merkmal der Schaltung ist die Vermeidung von sogenannten Shoot-Through-Effekten, also Kurzschlüssen, die entstehen können, wenn zwei Schaltelemente einer Reihenschaltung gleichzeitig leitend werden. Solche Kurzschlüsse führen zu hohen Verlustströmen und können die Schaltung dauerhaft beschädigen. Die vorliegende Gleichrichterschaltung adressiert dieses Problem durch mehrere Ansätze.

Durch den gezielten Einsatz richtungsabhängiger Schaltungselemente, die den Umschaltvorgang der steuerbaren Schaltelemente beschleunigen, wird sichergestellt, dass immer nur eines der beiden Schaltelemente in einer Reihenschaltung leitend ist, während das andere vollständig gesperrt bleibt. Diese Funktionalität reduziert nicht nur das Risiko von Kurzschlüssen erheblich, sondern minimiert auch Umschaltverluste und sorgt für eine höhere Energieeffizienz.

Ein weiterer Vorteil liegt in der präzisen Steuerung der Schaltelemente. Dies sorgt dafür, dass die Steuersignale stets optimal an die Schaltschwellen der Transistoren angepasst sind, was ein präzises Umschalten ohne zeitliche Überlappung ermöglicht. Dies trägt maßgeblich dazu bei, dass die Schaltung auch bei hohen Frequenzen stabil und zuverlässig arbeitet, ohne die Gefahr eines Shoot-Through-Effekts.

Neben der Vermeidung von Kurzschlüssen bietet die Schaltung weitere Vorteile im Hinblick auf Energieeffizienz und Verlustminimierung. Die bevorzugte Verwendung von MOSFETs mit niedrigem Durchlasswiderstand und richtungsabhängigen Schaltungselementen, bevorzugt schnellschaltende Dioden, wie bspw. Schottky-Dioden, reduziert den Spannungsabfall und somit die Leistungsverluste. Dadurch wird nicht nur die Wärmeentwicklung verringert, sondern auch der Bedarf an Kühlmaßnahmen reduziert, was eine kompaktere Bauweise der Schaltung ermöglicht.

Ein zusätzlicher Vorteil der Schaltung ist ihre hohe Flexibilität und Sicherheit bei variabler Polarität der Eingangsspannung. Der integrierte Verpolungsschutz stellt sicher, dass die Schaltelemente auch bei umgekehrter Polarität korrekt gesteuert werden, wodurch Schäden an der Schaltung und der angeschlossenen Last vermieden werden.

Zusammengefasst bietet die vorliegende Gleichrichterschaltung eine Lösung, die Kurzschlüsse und Umschaltverluste vermeidet, hohe Effizienz gewährleistet und einen zuverlässigen Betrieb auch unter anspruchsvollen Bedingungen ermöglicht. Diese Eigenschaften machen die Schaltung besonders geeignet für Anwendungen mit hohen Anforderungen an Sicherheit, Energieeffizienz und Kompaktheit, bspw. bei Antriebsvorrichtungen für Öffnungselemente.

Die Aufgabe der Erfindung wird damit vollkommen gelöst.

Bei einer Weiterbildung der Erfindung nach Anspruch 2 sind die steuerbaren Schaltelemente als Transistoren ausgeführt.

Der Einsatz von Transistoren reduziert die Abfallspannung und die Verlustleistung im Vergleich zu herkömmlichen Dioden-Gleichrichtern, was zu einer höheren Effizienz der Schaltung führt.

Bei einer Weiterbildung der Erfindung nach Anspruch 3 handelt es sich bei den Transistoren um MOSFETs, die aufgrund ihrer geringen Durchlassverluste und kurzen Schaltzeiten besonders geeignet sind. Die Verwendung von MOSFETs ermöglicht besonders schnelles Umschalten und minimiert dadurch Umschaltverluste, was die Wärmeentwicklung reduziert und kompaktere Designs erlaubt.

Gemäß einer Weiterbildung der Erfindung nach Anspruch 4 sind die richtungsabhängigen Schaltungselemente als Dioden ausgeführt, insbesondere als schnellschaltende Dioden, wie Schottky-Dioden, die geringe Umschaltverluste aufweisen.

Schnellschaltende Dioden, insbesondere Schottky-Dioden, sorgen für eine noch höhere Effizienz der Schaltung und ermöglichen eine kompakte Bauweise der Antriebsvorrichtung durch verringerte Verlustleistung.

Bei einer Weiterbildung der Erfindung nach Anspruch 5 ist die Steuerschaltung der Antriebsvorrichtung so ausgelegt, dass sie zumindest zwei unterschiedliche Steuersignale erzeugt, die abhängig von der Polung der Eingangsspannung die Schaltelemente steuern.

Die Steuerschaltung gewährleistet eine sichere und zuverlässige Funktion unabhängig von der Polung der Eingangsspannung, wodurch der Betrieb der Antriebsvorrichtung stabilisiert wird.

Bei einer bevorzugten Ausführung nach Anspruch 6 umfasst die Steuerschaltung vier Spannungsteiler, wobei jeder Spannungsteiler eine Ausgangsspannung als Steuersignal bereitstellt, das jeweils einem Schaltelement zugeordnet ist.

Die Verwendung von Spannungsteilern ermöglicht eine präzise Steuerung der Schaltelemente bei geringem baulichem Aufwand, wodurch die Effizienz und Zuverlässigkeit der Schaltung weiter erhöht werden.

Gemäß einer weiteren Ausgestaltung nach Anspruch 7 sind jeweils zwei Spannungsteiler in Reihe geschaltet, wobei die beiden Reihenschaltungen zwischen den Eingängen der Gleichrichterschaltung angeordnet sind. Dabei ist eine Reihenschaltung dem ersten und dem zweiten Schaltelement und die andere Reihenschaltung dem dritten und vierten Schaltelement zugeordnet.

Der Spannungsteiler ist für die erforderliche Ansteuerspannung der Schaltelemente notwendig..

Bei einer weiteren Ausführungsform nach Anspruch 8 erzeugen die beiden Reihenschaltungen jeweils eine erste und eine davon unterscheidende zweite Ausgangsspannung, um abhängig von der Polung der Eingangsspannung das erste Paar von Schaltelementen zu öffnen bzw. zu schließen und das zweite Paar zu schließen bzw. zu öffnen.

Diese Anordnung ermöglicht ein zuverlässiges Umschalten zwischen den Schaltelementen, was die Effizienz und den zuverlässigen Betrieb der Antriebsvorrichtung weiter verbessert.

Es versteht sich, dass die vorstehend genannten und die nachstehend noch zu erläuternden Merkmale nicht nur der jeweils angegebenen Kombination, sondern auch in anderen Kombinationen oder in Alleinstellung verwendbar sind, ohne den Rahmen der vorliegenden Erfindung zu verlassen.

Weitere Vorteile und Ausgestaltungen der Erfindung ergeben sich aus der Beschreibung und der beiliegenden Zeichnung. Dabei zeigen:
- Figur 1: schematische Darstellung einer Anlage mit einem elektrisch angetriebenen Öffnungselement eines Gebäudes;
- Figur 2: ein schematisches Blockschaltbild einer Gleichrichterschaltung für einen Antrieb der Anlage;
- Figur 3: ein Schaltbild einer Gleichrichterschaltung; und

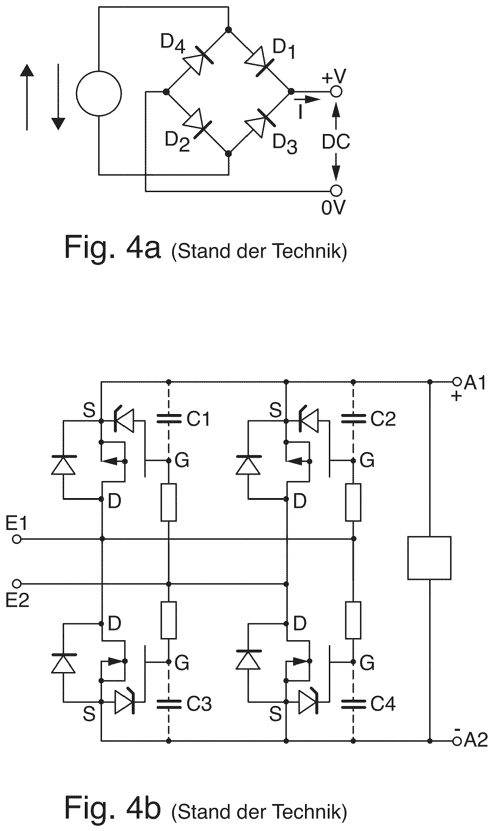

- Figuren 4a,b: Schaltbilder zweier Gleichrichterschaltungen aus dem Stand der Technik.

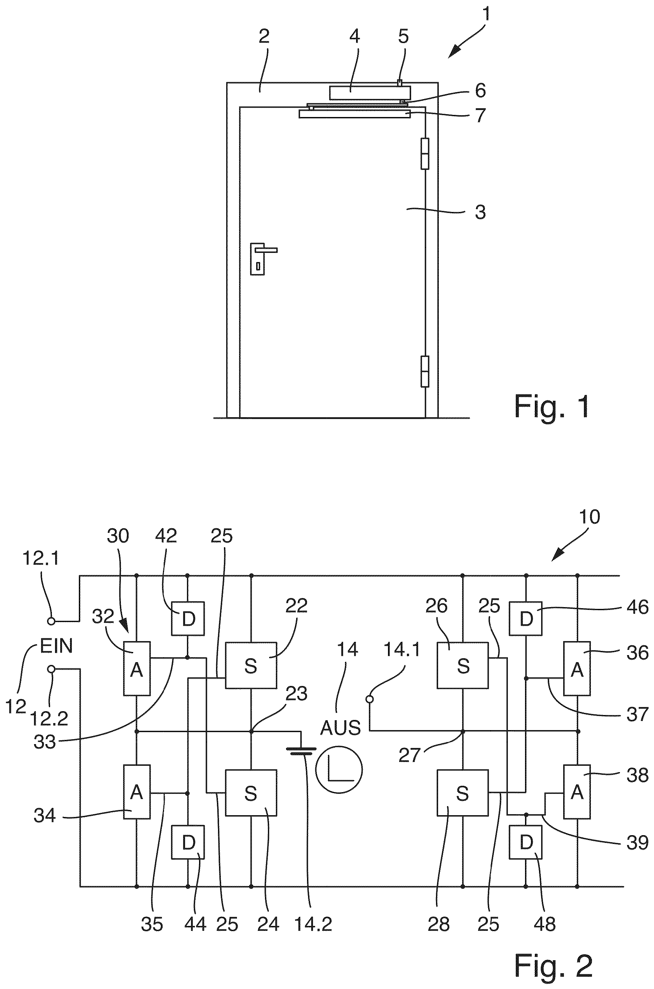

Zur Verdeutlichung, in welchem technischen Umfeld die erfindungsgemäße Antriebsvorrichtung eingesetzt wird, ist in Fig. 1 eine Anlage 1 mit einem als Drehflügel ausgebildeten Türflügel 3 dargestellt. Der Türflügel 3, welcher über Scharniere drehbar an einer ortsfesten Zarge 2 gelagert ist, ist über ein als Gleitarm 6 ausgebildetes, mit dem Abtriebsglied 5 einer ortsfest angeordneten Antriebsvorrichtung 4 verbundenes Gestänge und eine Gleitschiene 7 antreibbar. Die Antriebsvorrichtung 4 mit einem elektrische Motor ist beispielsweise angesteuert durch einen (nicht dargestellten) Sensor, der eine sich annähernde und/oder sich im Bereich der Türanlage befindende Person erfasst. Die gezeigte Anlage steht dabei stellvertretend für eine Anlage mit zumindest einem Öffnungselement als Teil eines Gebäudes zum Öffnen und Schließen einer Gebäudeöffnung, wobei das Öffnungselement über eine elektrische Antriebseinrichtung, die über bspw. eine Gleichspannung mit Energie versorgt wird, geöffnet und/oder geschlossen werden kann.

Die Antriebsvorrichtung 4 enthält unter anderem eine Gleichrichterschaltung 10, die dafür sorgt, dass unabhängig von der Polarität der Gleichspannung der Motor immer mit einer gleichen definierten Polarität versorgt wird. Oder anders ausgedrückt dient die Gleichrichterschaltung 10 unter anderem als Verpolungsschutz für die Antriebsvorrichtung, insbesondere den Motor oder entsprechende Motortreiberschaltungen.

In Figur 2 ist eine solche Gleichrichterschaltung 10 als Blockschaltbild gezeigt. Der Aufbau der Gleichrichterschaltung 10 ähnelt konstruktiv einer sogenannten H-Brückenschaltung (bei einer üblichen H-Brückenschaltung ist jeweils ein Paar von n-Kanal und p-Kanal MOSFET in Reihe geschaltet, während hier ein Paar von n-Kanal-MOSFETs und ein Paar aus p-Kanal MOSFETs jeweils in Reihe geschaltet sind, wie später noch ausgeführt werden wird) und ermöglicht es, den Stromfluss durch die Last L immer in eine definierte Richtungen zu steuern, d.h. eine Ausgangsspannung mit gleichbleibender Polarität bereitzustellen, unabhängig von der Polarität der angelegten Eingangsspannung.

Die H-Brückenschaltung (trotz der Unterschiede zu einer klassischen H-Brückenschaltung wird dieser Begriff der Einfachheit halber hier weiter verwendet) verfügt über einen ersten und einen zweiten Eingang 12, 12.1, 12.2, an denen eine Eingangsspannung anlegbar ist. Diese Spannung kann eine Gleichspannung mit variabler Polarität sein. Darüber hinaus besitzt die Gleichrichterschaltung 10 einen ersten und einen zweiten Ausgang 14, 14.1, 14.2, die mit der elektrischen Last L direkt oder indirekt verbunden sind. Über diese Ausgänge 14 wird die Polarität der an der Last anliegenden Spannung festgelegt, um den Stromfluss in die gewünschte Richtung zu ermöglichen.

Zur Steuerung des Stromflusses umfasst die Gleichrichterschaltung 10 vier steuerbare Schaltelemente 22, 24, 26, 28. Diese Schaltelemente sind so angeordnet, dass jeweils zwei davon in Reihe 22, 24 bzw. 26, 28 zwischen dem ersten und dem zweiten Eingang 12.1, 12.2 geschaltet sind. Die in Reihe geschalteten Schaltelemente 22, 24 und 26, 28 bilden jeweils einen Verbindungspunkt 27, 23, von dem aus der erste 14.1 bzw. der zweite Ausgang 14.2 gespeist wird. Jedes Schaltelement 22, 24, 26, 28 verfügt über einen Steuereingang 25, über den es in einen leitenden oder sperrenden Zustand versetzt werden kann.

Die Gleichrichterschaltung wird durch eine Steuerschaltung 30, die vorzugsweise vier Steuerschaltungselemente 32, 34, 36, 38 aufweist, ergänzt. Die Steuerschaltung 30 ist ausgelegt, die vier Schaltelemente 22, 24, 26 und 28 vorzugsweise paarweise anzusteuern. Dabei wird ein erstes Paar aus dem ersten und vierten Schaltelement 22, 28 sowie ein zweites Paar aus dem zweiten und dritten Schaltelement 24, 26 gebildet. Abhängig von der Polarität der Eingangsspannung und der gewünschten Stromflussrichtung wird entweder das erste oder das zweite Paar der Schaltelemente aktiviert, d.h. stromleitend geschaltet, während das jeweils andere Paar deaktiviert, d.h. stromsperrend, geschaltet. Dadurch kann der Stromfluss durch die Last immer in die gewünschten Richtung gesteuert werden, so dass die Polarität an den Ausgängen 14.1 und 14.2 gleich bleibt.

Liegt beispielsweise eine positive Spannung zwischen den Eingängen 12.1 und 12.2, werden das zweite und dritte Schaltelement in den leitenden Zustand versetzt, während das erste und vierte Schaltelement gesperrt werden. Liegt beispielsweise eine negative Spannung zwischen den Eingängen 12.1 und 12.2, werden das erste und vierte Schaltelement leitend geschaltet, während das zweite und dritte Schaltelement sperren.

Die Gleichrichterschaltung ist zusätzlich mit richtungsabhängigen Schaltungselementen 42, 44, 46, 48 ausgestattet. Der Begriff "richtungsabhängiges Schaltungselement" beschreibt allgemein ein Bauelement, das eine Leitfähigkeit in Abhängigkeit von der Richtung des Stromflusses aufweist, oder anders ausgedrückt den Stromfluss abhängig von der Polarität der angelegten Spannung steuert, indem es in einer Richtung eine niedrige Impedanz und in der entgegengesetzten Richtung eine hohe Impedanz bietet.

Das erste richtungsabhängigen Schaltungselement 42 verbindet den Steuereingang 25 des zweiten Schaltelements 24 mit dem ersten Eingang 12.1. Die Richtung des Stromflusses ist vom Steuereingang zum ersten Eingang 12.1. Das zweite richtungsabhängigen Schaltungselement 44 verbindet den Steuereingang 25 des ersten Schaltelements 22 mit dem zweiten Eingang 12.2. Die Richtung des Stromflusses ist vom Steuereingang zum zweiten Eingang 12.2.

Das dritte richtungsabhängigen Schaltungselement 46 verbindet den Steuereingang 25 des vierten Schaltelements 28 mit dem ersten Eingang 12.1. Die Richtung des Stromflusses ist vom ersten Eingang 12.1 zum Steuereingang. Das vierte richtungsabhängigen Schaltungselement 48 verbindet den Steuereingang 25 des dritten Schaltelements 26 mit dem zweiten Eingang 12.2. Die Richtung des Stromflusses ist vom zweiten Eingang 12.2 zum Steuereingang.

Die richtungsabhängigen Schaltungselemente 42, 44, 46, 48 in der H-Brückenschaltung erfüllen eine entscheidende Funktion, um die Umschaltzeiten der steuerbaren Schaltelemente 22, 24, 26, 28 zu optimieren und die Betriebssicherheit der Gleichrichterschaltung zu erhöhen. Diese Schaltungselemente sind so angeordnet, dass sie jeweils einem der steuerbaren Schaltelemente zugeordnet sind. Ihr Haupteinsatzgebiet liegt in der Unterstützung des schnellen und kontrollierten Übergangs zwischen den Betriebszuständen der Schaltelemente, also dem Wechsel vom leitenden in den sperrenden Zustand und umgekehrt.

Eine der wesentlichen Herausforderungen in H-Brückenschaltungen besteht darin, sogenannte Shoot-Through-Effekte zu vermeiden. Diese Effekte treten auf, wenn die beiden Schaltelemente einer Reihenschaltung, die zwischen den Eingängen angeordnet sind, für eine sehr kurze Zeitspanne gleichzeitig leitend sind. In diesem Fall könnte ein Kurzschluss zwischen den beiden Eingängen entstehen, was eine hohe Verlustleistung erzeugt und die Bauteile schädigen kann.

Die richtungsabhängigen Schaltungselemente greifen genau an dieser Stelle ein. Sie sorgen dafür, dass die Umschaltzeiten der Schaltelemente verkürzt werden, indem sie parasitäre Ladungen, die sich im Schaltelement während des Umschaltens ansammeln, schnell ableiten. Diese Ladungen können sich insbesondere in MOSFETs als sogenannte "Gate-Charge" oder durch kapazitive Effekte an den Drain-Source-Strecken bilden. Wenn diese Ladungen nicht effizient abgeführt werden, kann das Schaltelement länger im leitenden Zustand verbleiben, was zu den oben genannten Kurzschlussproblemen führt.

Die richtungsabhängigen Schaltungselemente ermöglichen einen gezielten und schnellen Entladungsweg für diese parasitären Ladungen und reduzieren somit die Verzögerung beim Übergang der Schaltelemente in den sperrenden Zustand. Dadurch wird sichergestellt, dass stets nur eines der Schaltelemente einer Reihenschaltung leitend ist, während das andere sicher gesperrt bleibt. Dies verhindert nicht nur unerwünschte Kurzschlussströme, sondern verbessert auch die Gesamtenergieeffizienz der Schaltung, da unnötige Leistungsverluste minimiert werden.

Ein weiterer Vorteil der richtungsabhängigen Schaltungselemente ist ihre Fähigkeit, den Betrieb der Schaltelemente bei hohen Schaltfrequenzen zu stabilisieren. Insbesondere in Anwendungen, bei denen die H-Brückenschaltung mit hohen Frequenzen arbeitet, können langsame Umschaltzeiten erhebliche Probleme verursachen. Die Schaltungselemente sorgen dafür, dass die Schaltvorgänge auch bei solchen Bedingungen präzise und zuverlässig erfolgen, was die Funktionalität und Lebensdauer der gesamten Schaltung erhöht.

In einer bevorzugten Ausführung werden richtungsabhängige Schaltungselemente verwendet, die eine besonders geringe Sperrverzögerung und niedrige Verluste aufweisen. Diese Eigenschaften machen sie optimal für Anwendungen in H-Brückenschaltungen geeignet. Die Kombination aus ihrer hohen Schaltgeschwindigkeit und der Fähigkeit, parasitäre Effekte zu unterdrücken, macht diese richtungsabhängigen Schaltungselemente zu einem wichtigen Bestandteil der H-Brückenschaltung.

Zusammenfassend lässt sich festhalten, dass die richtungsabhängigen Schaltungselemente 42, 44, 46, 48 eine doppelte Aufgabe erfüllen: Sie beschleunigen den Schaltvorgang der steuerbaren Schaltelemente 22, 24, 26, 28 und verhindern dadurch potenzielle Kurzschlusszustände. Gleichzeitig verbessern sie die Effizienz und Stabilität der Schaltung, insbesondere bei hohen Schaltfrequenzen, und tragen wesentlich zur Betriebssicherheit bei. Ihre Einbindung in die H-Brückenschaltung ist daher eine essenzielle Maßnahme zur Optimierung der Schaltungsperformance.

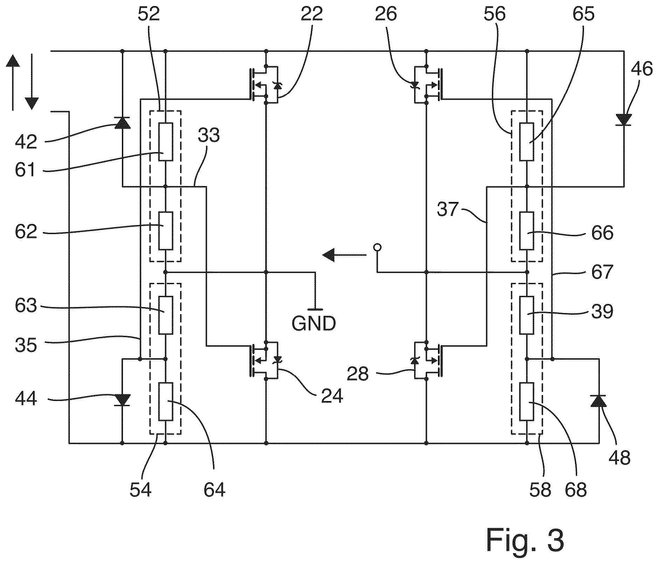

In Figur 3 ist nun eine Gleichrichterschaltung 10 im Detail dargestellt. Die Steuerelemente 32, 34, 36, 38 zur Ansteuerung der Schaltelemente 22, 24, 26, 28 in der H-Brückenschaltung sind jeweils als Spannungsteiler aus zwei Widerständen 61, 62 bzw. 63, 64 bzw. 65, 66 bzw. 67, 68 ausgeführt. Jeder Spannungsteiler besteht aus einem oberen 61, 63, 65, 67 und einem unteren 62, 64, 66, 68 Widerstand, die in Serie geschaltet sind. Der Mittelabgriff zwischen diesen beiden Widerständen wird als Steuersignal/Steuerleitung 33, 35, 37, 39 genutzt, um das zugehörige Schaltelement 22, 24, 26, 28 in einen leitenden oder sperrenden Zustand zu versetzen.

Insgesamt umfasst die Schaltung vier Spannungsteiler 52, 54, 56, 58, wobei jeweils zwei Spannungsteiler 52, 54 bzw. 56, 58 in Reihe zwischen den beiden Eingängen 12.1 und 12.2 der Gleichrichterschaltung angeordnet sind. Diese Anordnung sorgt für eine präzise und symmetrische Spannungsverteilung. Die beiden Spannungsteiler 54, 58 sind den oberen Schaltelementen 22, 26 zugeordnet, während die beiden andere Spannungsteiler 52, 56 die unteren Schaltelemente 24, 28 steuert. Diese Konfiguration stellt sicher, dass die Steuersignale abhängig von der anliegenden Eingangsspannung generiert werden.

Die Widerstände in jedem Spannungsteiler sind bspw. gleich dimensioniert. Diese Symmetrie gewährleistet, dass bei einer bestimmten Eingangsspannung ein definiertes Steuersignal 33, 35, 37, 39 am Mittelabgriff erzeugt wird, das optimal an die Schaltschwelle der Schaltelemente angepasst ist. Die Wahl gleicher Widerstandswerte sorgt außerdem dafür, dass die Schaltung unabhängig von Schwankungen der Eingangsspannung stabil arbeitet und die Steuersignale stets die erforderlichen Pegel für die zuverlässige Ansteuerung der Schaltelemente erreichen. Es versteht sich jedoch, dass die Widerstände der Spannungsteiler auch unterschiedlich dimensioniert sein können. Wichtig ist lediglich, dass bei einer bestimmten Polarität an den Eingängen bestimmte Steuersignale erzeugt werden.

Durch die präzise Dimensionierung der Widerstände wird sichergestellt, dass das Steuersignal auch bei variabler Polarität der Eingangsspannung die gewünschte Steuerung der Schaltelemente ermöglicht. Diese Anordnung reduziert nicht nur die Komplexität der Steuerung, sondern trägt auch zur hohen Effizienz und Zuverlässigkeit der H-Brückenschaltung bei.

Wie sich ebenfalls aus Figur 3 ergibt, sind die Schaltelemente 22, 24, 26, 28 der H-Brückenschaltung als Transistoren ausgebildet, wobei bevorzugt MOSFETs (Metal-Oxide-Semiconductor Field-Effect Transistors) zum Einsatz kommen. Diese Transistoren zeichnen sich durch ihre hohe Schaltgeschwindigkeit, geringen Durchlasswiderstand und hohe Energieeffizienz aus, was sie besonders geeignet für Anwendungen in H-Brückenschaltungen macht.

In einer bevorzugten Ausführung werden unterschiedliche Arten von MOSFETs verwendet, um eine optimale Funktion der Schaltung sicherzustellen. Insbesondere kommen n-Kanal-MOSFETs für die in Figur 3 linken Schaltelemente 22, 24 der H-Brücke zum Einsatz. Für die rechten Schaltelemente 26, 28 werden p-Kanal-MOSFETs verwendet.. Die Verwendung von p-Kanal-MOSFETs statt n-Kanal-MOSFETs im rechten Zweig bietet den Vorteil, dass für die Gate-Ansteuerung kein aktives Bauelement wie z. B. eine Ladepumpe benötigt wird, um das Steuersignal am Gate über das Potential der Versorgungsspannung anzuheben und somit ein Durchschalten des Transistors zu ermöglichen, d. h. an den p-Kanal-MOSFETs können einfache passive Bauelemente wie z. B. Widerstände für die Ansteuerung verwendet werden. Desweiteren sind die Widerstände so dimensioniert und verbunden, dass sich die MOSFETs selbstständig in Abhängigkeit der Eingangspolarität automatisch richtig schalten, was eine allgemeine und uneingeschränkte Nutzung dieser Schaltung für viele Anwendungen ermöglicht. Diese Anordnung von zwei n-Kanal-MOSFETs auf der linken Seite und zwei p-Kanal-MOSFETs auf der rechten Seite der in Figur 3 gezeigten Schaltung unterscheidet diese Brückenschaltung von einer klassischen H-Brückenschaltung.

Zur Unterstützung und Stabilisierung der Schaltvorgänge sind die richtungsabhängigen Schaltungselemente 42, 44, 46, 48 als Dioden ausgebildet, die jeweils einem Schaltelement zugeordnet sind. Diese Dioden sorgen dafür, dass parasitäre Effekte minimiert und Umschaltzeiten reduziert werden. Insbesondere bevorzugt werden Schottky-Dioden verwendet, da sie durch ihren geringen Spannungsabfall und ihre kurze Schaltzeit ideal für den Einsatz in dieser Schaltung geeignet sind. Die geringe Durchlassspannung der Schottky-Dioden trägt dazu bei, die Verluste in der Schaltung weiter zu minimieren und die Effizienz zu maximieren.

Die Kombination aus n-Kanal- und p-Kanal-MOSFETs als Schaltelemente und schnellschaltenden Dioden, bspw. Schottky-Dioden, als richtungsabhängige Schaltungselemente gewährleistet einen zuverlässigen und energieeffizienten Betrieb der H-Brückenschaltung. Diese Konfiguration ermöglicht eine präzise Steuerung des Stromflusses durch die elektrische Last, eine Minimierung von Verlusten und eine Reduzierung potenzieller Kurzschlussrisiken während des Umschaltens. Gleichzeitig wird die Schaltung durch die geringe Verlustleistung und die optimierte Wärmeentwicklung besonders kompakt und langlebig gestaltet.

Zusammenfassend stellt die vorliegende Erfindung eine verbesserte H-Brückenschaltung zur Ansteuerung elektrischer Lasten, wie beispielsweise eines Antriebs für ein Öffnungselement eines Gebäudes, dar. Die Schaltung kombiniert steuerbare Schaltelemente, bevorzugt in Form von MOSFETs, mit richtungsabhängigen Schaltungselementen, wie bevorzugt Schottky-Dioden, und einer präzisen Steuerung mittels Spannungsteilern. Diese Konfiguration ermöglicht eine zuverlässige und effiziente Steuerung des Stromflusses durch die Last, unabhängig von der Polarität der Eingangsspannung.

Ein wesentlicher Vorteil der Erfindung liegt in der integrierten Funktion des Verpolungsschutz. Selbst bei einer fehlerhaften Polarität der angelegten Eingangsspannung wird sichergestellt, dass die Schaltelemente korrekt angesteuert werden, wodurch Schäden an der Schaltung und der Last zuverlässig vermieden werden. Die richtungsabhängigen Schaltungselemente spielen hierbei eine entscheidende Rolle, da sie sowohl den Schutz der Steuerlogik als auch die Stabilität der Umschaltvorgänge gewährleisten.

Zusätzlich bietet die Erfindung erhebliche Vorteile in Bezug auf Energieeffizienz und Sicherheit. Die Verwendung von Schottky-Dioden minimiert den Spannungsabfall und reduziert Umschaltverluste, während die MOSFETs mit ihrem niedrigen Durchlasswiderstand eine hohe Leistung bei minimaler Wärmeentwicklung sicherstellen. Die Anordnung jeweils einer Dioden am jeweiligen Gate eines MOSFETs verhindert zuverlässig Kurzschlüsse während des Umschaltens und verbessert die Dynamik der Schaltung auch bei hohen Schaltfrequenzen.

Die Erfindung eignet sich daher besonders für Anwendungen, bei denen ein zuverlässiger Betrieb unter variablen Bedingungen, wie wechselnder Polarität der Eingangsspannung, erforderlich ist. Gleichzeitig ermöglicht die kompakte Bauweise der Schaltung eine einfache Integration in moderne Systeme, insbesondere in elektrischen Antriebssystemen. Mit dieser Lösung wird eine hohe Leistungsfähigkeit, Energieeffizienz und Sicherheit kombiniert, wodurch die Schaltung vielseitig einsetzbar und zukunftsfähig ist.

### Bezugszeichenliste

- 1: Anlage
- 2: Zarge
- 3: Türflügel
- 4: Antriebsvorrichtung
- 5: Abtriebsglied
- 6: Gleitarm
- 7: Gleitschiene
- 10: Gleichrichterschaltung
- 12: Eingang
- 14: Ausgang
- 23,27: Verbindungspunkt
- 22-28: Schaltelemente
- 30: Steuerschaltung
- 32-38: Steuerschaltungselemente
- 33-39: Steuersignal
- 42-48: richtungsabhängige Schaltungselemente
- 52-58: Spannungsteiler
- 61-68: Widerstände

## Patentansprüche

1. Antriebsvorrichtung für ein Öffnungselement, bspw. eine Tür, ein Fenster oder dgl., eines Gebäudes, mit
einem elektrischen Antrieb zum Öffnen und/oder Schließen des Öffnungselements, und
einer Gleichrichterschaltung (10), die aufweist:
einen ersten und einem zweiten Eingang (12.1, 12.2), an denen eine Eingangsspannung anlegbar ist;
einem ersten und einem zweiten Ausgang (14.1, 14.2), die mit dem elektrischen Antrieb verbunden sind;
vier über Steuereingänge steuerbare Schaltelemente (22, 24, 26, 28),
wobei ein erstes und ein zweites Schaltelement (22, 24) in Reihe zwischen dem ersten Eingang und dem zweiten Eingang angeordnet sind und zwischen sich einen ersten Verbindungspunkt bilden, der mit dem ersten Ausgang verbunden ist, und wobei ein drittes und ein viertes Schaltelement (26, 28) in Reihe zwischen dem ersten Eingang und dem zweiten Eingang angeordnet sind und zwischen sich einen zweiten Verbindungspunkt bilden, der mit dem zweiten Ausgang verbunden ist;
einer Steuerschaltung (30; 32, 34, 36, 38), die so konfiguriert ist, dass sie die Schaltelemente abhängig von der Polung der Eingangsspannung paarweise über die Steuereingänge ansteuert, wobei ein erstes Paar aus dem ersten Schaltelement (22) und dem vierten Schaltelement (28) gebildet ist, und ein zweites Paar aus dem zweiten Schaltelement (24) und dem dritten Schaltelement (26) gebildet ist, um den Stromfluss unabhängig von der Polung der Eingangsspannung durch die elektrische Last in einer Richtung zu ermöglichen;
**gekennzeichnet durch**
vier richtungsabhängige Schaltungselemente (42, 44, 46, 48), wobei jedem Schaltelement jeweils ein richtungsabhängiges Schaltungselement zugeordnet ist, dergestalt, dass ein richtungsabhängiges Schaltungselement mit dem Steuereingang des zugeordneten Schaltelements und dem ersten oder dem zweiten Eingang verbunden ist.

2. Antriebsvorrichtung nach Anspruch 1, **dadurch gekennzeichnet, dass** die steuerbaren Schaltelemente (22, 24, 26, 28) Transistoren sind.

3. Antriebsvorrichtung nach Anspruch 2, **dadurch gekennzeichnet, dass** die Transistoren MOSFET Transistoren sind.

4. Antriebsvorrichtung nach Anspruch 1 oder 2, **dadurch gekennzeichnet, dass** die richtungsabhängigen Schaltungselemente (42, 44, 46, 48) Dioden sind, insbesondere schnellschaltende Dioden, insbesondere Schottky-Dioden.

5. Antriebsvorrichtung nach einem der vorhergehenden Ansprüche, **dadurch gekennzeichnet, dass** die Steuerschaltung (30) ausgelegt ist, zumindest zwei unterschiedliche Steuersignale abhängig von der Polung der Eingangsspannung zu erzeugen.

6. Antriebsvorrichtung nach Anspruch 5, **dadurch gekennzeichnet, dass** die Steuerschaltung (30) vier Spannungsteiler (32, 34, 36, 38) aufweist, wobei jeder Spannungsteiler eine Ausgangsspannung als Steuersignal bereitstellt und einem Schaltelement zugeordnet ist, und die Ausgangsspannung eines Spannungsteilers dem Steuereingang des zugeordneten Schaltelements zugeführt ist.

7. Antriebsvorrichtung nach Anspruch 6, **dadurch gekennzeichnet, dass** jeweils zwei Spannungsteiler (32,34; 36, 38) in Reihe geschaltet sind und die beiden Reihenschaltungen zwischen dem ersten und dem zweiten Eingang liegen, wobei eine Reihenschaltung dem ersten und dem zweiten Schaltelement und die andere Reihenschaltung dem dritten und dem vierten Schaltelement zugeordnet ist.

8. Antriebsvorrichtung nach Anspruch 7, **dadurch gekennzeichnet, dass** die beiden Reihenschaltungen eine erste und eine sich davon unterscheidende zweite Ausgangsspannung erzeugen, um abhängig von der Polung der Eingangsspannung das erste Paar von Schaltelementen zu öffnen bzw. zu schließen und das zweite Paar von Schaltelementen zu schließen bzw. zu öffnen.

9. Gleichrichterschaltung zur Versorgung eines elektrischen Antriebs für ein Öffnungselement eines Gebäudes mit einer Eingangsspannung, mit
einem ersten und einem zweiten Eingang (12.1, 12.2), an dem die Eingangsspannung anlegbar ist;
einem ersten und einem zweiten Ausgang (14.1, 14.2), an dem die elektrische Last anschließbar ist;
vier über Steuereingänge steuerbaren Schaltelementen (22, 24, 26, 28),
wobei ein erstes und ein zweites Schaltelement in Reihe zwischen dem ersten Eingang und dem zweiten Eingang angeordnet sind und zwischen sich einen ersten Verbindungspunkt bilden, der mit dem ersten Ausgang verbunden ist, und wobei ein drittes und ein viertes Schaltelement in Reihe zwischen dem ersten Eingang und dem zweiten Eingang angeordnet sind und einen zwischen sich einen zweiten Verbindungspunkt bilden, der mit dem zweiten Ausgang verbunden ist;
einer Steuerschaltung (30; 32, 34, 36, 38)), die so konfiguriert ist, dass sie die Schaltelemente abhängig von der Polung der Eingangsspannung paarweise über die Steuereingänge ansteuert, wobei ein erstes Paar aus dem ersten Schaltelement und dem vierten Schaltelement gebildet ist, und ein zweites Paar aus dem zweiten Schaltelement und dem dritten Schaltelement gebildet ist, um den Stromfluss unabhängig von der Polung der Eingangsspannung durch die elektrische Last in einer Richtung zu ermöglichen;
**gekennzeichnet durch**
vier richtungsabhängige Schaltungselemente (42, 44, 46, 48), wobei jedem Schaltelement jeweils ein richtungsabhängiges Schaltungselement zugeordnet ist, dergestalt, dass ein richtungsabhängiges Schaltungselement mit dem Steuereingang des zugeordneten Schaltelements und dem ersten oder dem zweiten Eingang verbunden ist.
